# EUROPEAN PATENT APPLICATION

(11) **EP 0 523 784 A1**
(43) Date of publication of application: **20.01.1993**
(21) Application number: 92202053.2
(22) Date of filing: 07.07.1992
(51) Int. Cl.: H01L 27/148, H01L 27/14, G01T 1/29, G01T 1/208

(54) **An image detector and a method of manufacturing such an image detector**

(30) Priority: 15.07.1991 GB 9115263; 21.10.1991 GB 9122314
(71) Applicant: PHILIPS ELECTRONICS UK LIMITED, Croydon CR9 3QR (GB); Philips Electronics N.V., 5621 BA Eindhoven (NL)
(72) Inventor: Powell, Martin John, c/o Philips Research Lab., Redhill, Surrey RH1 5HA (GB); French, Ian Douglas, c/o Philips Research Lab., Redhill, Surrey RH1 5HA (GB); Hughes, John Richard, c/o Philips Research Lab., Redhill, Surrey RH1 5HA (GB); Bird, Neil Christopher, c/o Philips Research Lab., Redhill, Surrey RH1 5HA (GB)
(74) Representative: Clark, Jane Anne (GB)

(57) **Abstract**

An image detector (100) has a substrate (1) carrying a series of layers of different materials patterned to define an array (2) of photosensitive elements (20) each having first (21) and second (22) opposed electrodes with the first electrode (21) being closer to the substrate (1) than the second electrode (22) and a plurality of switching elements (30), each switching element having first (31) and second (32) main electrodes and a control (33) electrode with the second main electrode (32) of each switching element 30 being connected to the second electrode (22) of an associated one of the photosensitive elements (20) and the first electrodes (21) of the photosensitive elements (20) being connected a common line (40). Each photosensitive element (20) has a first electrode (21) which is larger in area than its second electrode (22) so that the first electrode (21) extends laterally beyond the periphery (22a) of the second electrode (22) and the first electrode (21) of each photosensitive element (20) is formed from the same layer as one of the electrodes (31 or 33) of the associated switching element (30). This enables the number of required metallisation levels to be reduced and enables a detector to be provided which is easily electrically testable and has reduced parasitic capacitances and a reduced sensitivity to direct illumination.

## Description

This invention relates to an image detector and a method of manufacturing such an image detector.

Image detectors have previously been proposed which comprise a substrate carrying a series of layers of different materials patterned to define an array of photosensitive elements each having first and second opposed electrodes with the first electrode being closer to the substrate than the second electrode and a plurality of switching elements, each switching element having first and second main electrodes and a control electrode with the second main electrode of each switching element being connected to a common line.

US Patent No. 4736234 describes such an image detector. In the image detector described in US Patent No. 4736234, layers are first deposited and then patterned to define a matrix array of columns and rows of photodiodes. The photodiodes are separated by insulating material. Further layers are then deposited and patterned to define row and column conductors for connecting the rows and columns of photodiodes and to define a transistor at each point where a row and a column conductor cross so as to enable each photodiode to be accessed individually. As described in US Patent No. 4736234, the photodiodes share a common first electrode which extends completely across the substrate and which, in the example described, is formed of a material transparent to electromagnetic radiation to be detected by the image detector. Electromagnetic radiation thus has to pass first through the substrate and is incident on the photodiodes via the transparent common first electrode. In such an arrangement the passage of the electromagnetic radiation through the substrate may result in parallax errors and thus some loss in resolution. The transistors are provided on top of the photodiode array during the formation of the row and column conductors such that the gate electrodes and thus the row conductors lie over the top of the source and drain electrodes of the transistors. Such an arrangement may lead to unwanted parasitic thin film transistors being present in the structure. This structure also requires that separate metallisation levels be used to form the first and second electrodes of the photodiodes, and the source and drain and gate electrodes of the transistors.

EP-A-163956 describes various different types of image detectors in which the photosensitive elements are arranged in a matrix array of rows and columns. The majority of the detectors described in this European Patent Application employ semiconductor diodes as the switching elements. Accordingly the switching elements do not have control electrodes but rather are connected in back-to-back relation with the photosensitive elements so that the first electrodes of the diode switching elements are connected to the row conductors and the first electrodes of the photosensitive elements are connected to the column conductors. Although the use of diodes as switching elements may be satisfactory where the intensity of the incident electromagnetic radiation is high the poor noise performance of diodes makes them less useful at low electromagnetic radiation intensities.

In the example illustrated in Figures 6 and 7 of EP-A-163956, the switching elements are formed as thin-film transistors and the semiconductor layer providing the conduction channel region of each transistor is extended to form a photosensitive resistor. Accordingly, the semiconductor layer must be of a material and doping suitable for forming both the conduction channel region and the photosensitive resistors which inevitably results in a compromise so that the characteristics of the photosensitive elements and switching elements cannot be independently optimised. In this structure, the insulated gates of the transistors are first formed and then a further conductive layer has to be deposited and patterned to define the first electrodes of the photosensitive resistors prior to deposition of the semiconductor layer for forming the conduction channel regions of the transistors.

EP-A-163956 also describes, by way of the example illustrated in Figure 24, an image detector in which a matrix array of photosensitive diodes and associated diode switching elements is covered by a layer of sputtered silicon dioxide or silicon nitride to form a hard transparent oxide layer onto which a document may be placed to enable the photosensitive elements to detect light transmitted through the substrate and thence reflected from the document onto the photosensitive diodes.

According to one aspect of the present invention, there is provided an image detector comprising a substrate carrying a series of layers of different materials patterned to define an array of photosensitive elements each having first and second opposed electrodes with the first electrode being closer to the substrate than the second electrode and a plurality of switching elements, each switching element having first and second main electrodes and a control electrode with the second main electrode of each switching element being connected to the second electrode of an associated one of the photosensitive elements and the first electrodes of the photosensitive elements being connected to a common line, characterised in that each photosensitive element has a first electrode which is larger in area than its second electrode so that the first electrode extends laterally beyond the periphery of the second electrode and in that the first electrode of each photosensitive elements is formed from the same layer as one of the electrodes of the associated switching element.

In a second aspect, the present invention provides a method of manufacturing an image detector, which method comprises providing a series of layers of different materials on a substrate and patterning the layers to define an array of photosensitive elements each having first and second opposed electrodes with the first electrode being closer to the substrate and a plurality of switching elements, each switching element having first and second main electrodes and a control electrode with the second main electrode of each switching element being connected to the second electrode of an associated one of the photosensitive elements and the first electrodes of the photosensitive elements being connected to a common line, characterised by forming the first electrode of each photosensitive element to be larger in area than its second electrode so that the first electrode extends laterally beyond the periphery of the second electrode and forming the first electrode of each photosensitive from the same layer as one of the electrodes of the associated switching element.

In a image detector in accordance with the invention, the first electrode of each photosensitive element is formed from the same layer as one of the electrodes of the associated switching element. This enables a reduction in the number of metallisation levels. Each first electrode is, in addition, larger in area then the associated second electrode which allows a reduction in parasitic capacitances and thus a reduction in crosstalk within the image detector. The larger first electrodes of the photosensitive elements may act as light shields where electromagnetic radiation is incident on the detector array via the substrate so reducing sensitivity to back-illumination (that is illumination via the substrate), which may be of particular advantage where the detector is to be used in a reflection-type document scanning or copying machine. Furthermore, the connection between the second main electrode of each switching element and the associated photosensitive element is easily accessible for testing by electrical probe enabling individual switching elements and photosensitive elements to be tested.

The photosensitive elements may be arranged in a regular matrix of rows and columns of photosensitive elements with the control electrodes of the switching elements associated with a row of photosensitive elements connected together to a respective row electrode and the first main electrodes of the switching elements associated with a column of photosensitive elements connected together to a respective column electrode.

In one example, the first electrodes of the photosensitive elements may be formed from the same layer as the first main electrodes of the switching elements.

Where the first electrodes of the photosensitive elements are formed from the same layer as the first main electrodes of the switching elements, the image detector may be manufactured by providing a first conductive layer on the substrate and patterning the first conductive layer to define the control electrodes, providing at least one semiconductor layer on the first conductive layer, providing a second conductive layer over the semiconductor layer and patterning the semiconductor layer and the second conductive layer to define active device regions of the switching elements and the first and second electrodes of the switching elements and the first electrodes of the photosensitive elements, providing at least one further semiconductor layer over the second conductive layer and patterning the further semiconductor layer to define active regions of the photosensitive elements, providing an isolating insulative layer over the further semiconductor layer, patterning the insulating layer to define contact windows and providing a third conductive layer to connect the second electrode of each photosensitive element to the second main electrode of the associated switching element. Such a method enables the number of crossovers of the common electrode with other metallisation layers to be reduced thereby reducing capacitance problems.

In an alternative example, the first electrodes of the photosensitive elements may be formed from the same layer as the control electrodes of the switching elements. In this case, the image detector may be manufactured by providing a first conductive layer on the substrate and patterning the first conductive layer to define the control electrodes of the transistors and the first electrodes of the photosensitive elements, providing at least one semiconductor layer on the first conductive layer and patterning the semiconductor layer to define active device regions of the switching elements and of the photosensitive elements, providing at least one further conductive layer over the semiconductor layer and patterning the at least one further conductive layer to define the first and second electrodes of the switching elements and to connect the second electrode of each photosensitive element to the second main electrode of the associated switching element. Two further conductive layers may be provided and the two layers then patterned together so as to reduce the resistance of the interconnections. Such a method has the advantage of being a simpler process requiring fewer mask steps.

An energy conversion layer may be provided over the structure on the substrate for converting electromagnetic radiation with a first range of wavelengths into electromagnetic radiation with a second range of wavelengths detectable by the photosensitive elements. This enables the image detector to be used for, for example, detecting X-rays. In such a case, the energy conversion layer may be a phosphor layer. The energy conversion layer may be provided on a protective insulating layer provided over the photosensitive and switching elements, the protective insulating layer being at least partially transparent to electromagnetic radiation detectable by the photosensitive elements. The protective insulating layer serves to reduce capacitive coupling between the energy conversion layer and the array.

The switching elements may be thin-film transistors while the photosensitive elements may be photosensitive diodes.

A protective layer may be provided on the substrate to cover the array of photosensitive elements and associated switching elements, the substrate and the protective layer being at least partially transparent to electromagnetic radiation detectable by the photosensitive elements for enabling the photosensitive elements to detect electromagnetic radiation which has passed through the substrate and been reflected onto the photosensitive elements by an object placed on the protective layer. The protective layer could be, for example, a layer of polyimide, silicon dioxide or silicon nitride. With such a protective layer covering the array, an object, for example a document, of which an image is to be obtained can be placed directly upon the protective layer and, by directing electromagnetic radiation detectable by the photosensitive elements through the substrate onto the object, an image of the object can be formed by the photosensitive elements which detect electromagnetic radiation reflected by the object. The first electrodes of the photosensitive elements are larger than those respective second electrodes and so extend laterally beyond the second electrodes to shield the photosensitive elements from the electromagnetic radiation incident on the substrate.

Embodiments of the invention will now be described, by way of example, with reference to the accompanying drawings, in which:
Figure 1 illustrates, by way of a simplified schematic circuit, the principle of operation of an image detector in accordance with the invention;
Figure 2 is a schematic circuit layout of the array of photosensitive elements and associated switching elements of an image detector in accordance with the invention;
Figure 3 is a schematic plan view of part of an image detector in accordance with the invention illustrating only the conductive levels to show the geometric relationship between the electrodes of the photosensitive elements, the electrodes of the switching elements and row and column conductors of the image detector;
Figure 4 is a perspective view of an image detector in accordance with the invention illustrating only the conductive levels to show the geometric relationship between the electrodes of the photosensitive elements, the electrodes of the switching elements and row and column conductors of the image detector;
Figures 5a to 5h are cross-sectional views through part of a substrate and layers carried by the substrate for illustrating steps in a first example of a method in accordance with the invention for manufacturing an image detector, as illustrated by Figures 3 and 4, in accordance with the invention;
Figure 6 is a schematic plan view of part of a modified image detector in accordance with the invention illustrating only the conductive levels to show the geometric relationship between the electrodes of the photosensitive elements, the electrodes of the switching elements and row and column conductors of the image detector;
Figures 7a to 7d are cross-sectional views through part of a substrate and layers carried by the substrate for illustrating steps in a second example of a method in accordance with the invention for manufacturing the modified image detector illustrated by Figure 6; and
Figure 8 is a cross-sectional view of a further embodiment of an image detector in accordance with the invention.

It should be understood that the Figures are merely schematic and are not drawn to scale. In particular certain dimensions such as the thickness of layers or regions may have been exaggerated whilst other dimensions may have been reduced. It should also be understood that the same reference numerals are used throughout the Figures to indicate the same or similar parts.

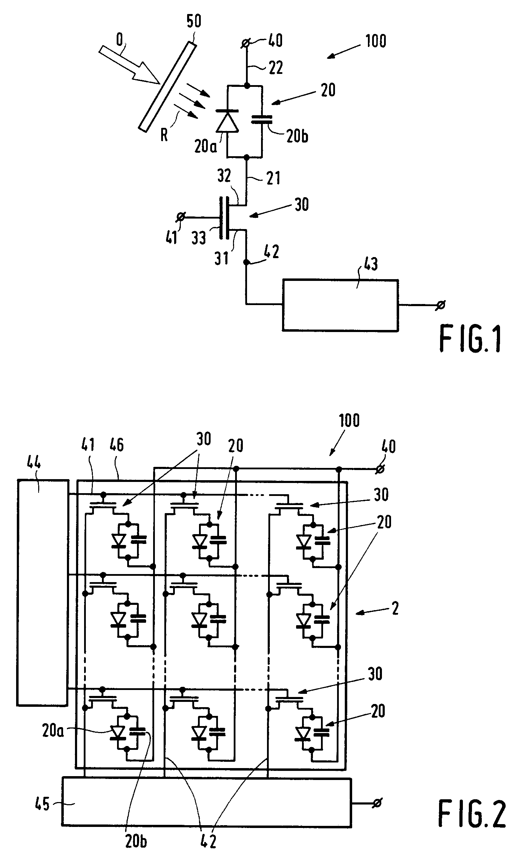

Referring now to the drawings, especially Figures 1 to 3 and 5h, there is illustrated an image detector 100 comprising a substrate 1 carrying a series of layers of different materials patterned to define an array 2 of photosensitive elements 20 each having first 21 and second 22 opposed electrodes with the first electrode 21 being closer to the substrate 1 than the second electrode 22 and a plurality of switching elements 30, each switching element having first 31 and second 32 main electrodes and a control 33 electrode with the second main electrode 32 of each switching element 30 being connected to the second electrode 22 of an associated one of the photosensitive elements 20 and the first electrodes 21 of the photosensitive elements 20 being connected a common line 40. In accordance with the invention, each photosensitive element 20 has a first electrode 21 which is larger in area than its second electrode 22 so that the first electrode 21 extends laterally beyond the periphery 22a of the second electrode 22 and the first electrode 21 of each photosensitive element 20 is formed from the same layer as one of the electrodes 31 or 33 of the associated switching element 30.

An image detector in accordance with the invention enables the number of required metallisation levels to be reduced. Also the fact that the first electrode 21 of each photosensitive element 20 is larger in area and connected to the common line allows a reduction, as will be described below, in unwanted parasitic capacitances. The larger first electrodes 21 may act as light shields against electromagnetic radiation incident via the substrate 1 which may be of particular advantage where the image detector is to be used in a reflection-type document scanning or copying machine. Furthermore, the connection between the second main electrode 32 of each switching element 30 and the associated photosensitive element 20 is easily accessible for testing by electrical probe so allowing testing of individual switching elements 30 and photosensitive elements 20.

Turning now specifically to the drawings, Figure 1 illustrates the basic operational principle of an image detector in accordance with the invention.

As shown in Figure 1, electromagnetic radiation 0 with a first range of wavelengths is incident on an energy conversion layer 50 of the image detector 100 which converts the incident electromagnetic radiation 0 into outgoing electromagnetic radiation R with a second range of wavelengths detectable by the array 2 of photosensitive elements 20. In this example, the incident electromagnetic radiation 0 comprises X-radiation and the outgoing electromagnetic radiation R comprises visible light. In such a case, the energy conversion layer 50 may be a phosphor layer, for example a layer of thallium-doped caesium iodide. Although other phosphors could be used, the use of thallium-doped caesium iodide has advantages in that the spectrum of the emitted electromagnetic radiation R peaks in the range of 400 to 700nm (nanometres) which is the most responsive range of amorphous silicon photodiodes. In addition, caesium iodide has a columnar structure which provides a sort of light-guiding effect, so reducing scattering problems.

The outgoing electromagnetic radiation is incident on the array 2 of photosensitive elements 20, in this example photosensitive diodes. The array 2 is illustrated schematically in Figure 1 by a single photosensitive element 20 which is shown as a diode 20a in parallel with a capacitor 20b which in this case represents the parasitic or self capacitance of the diode 20a but which may also include an additional capacitor to improve the dynamic range of the detector. The first electrode 21 of the photosensitive diode 20, represented by the cathode of diode 20a is connected to the common line 40 as will be described below while the second electrode 22 of the photosensitive diode, represented by the anode of the diode 20a, is connected to the second electrode 32 of the associated switching element 30, in this example to the drain electrode of a thin-film transistor 30. The control or gate electrode 33 of the thin-film transistor 30 is connected to a row conductor 41 while the first or source electrode 31 of the thin-film transistor 30 is connected via a column conductor 42 to a charge sensitive readout amplifier 43 of a conventional type. A readout arrangement of the type described in EP-A-440282 could also be used.

Figure 2 illustrates schematically the circuit layout of an area of the photodetector array 2. In this example, the array 2 comprises a two dimensional array of photodiodes 20 with a pitch of typically 200µm (micrometres) or less and an overall size of up to 400 by 400mm to achieve the sort of resolution required where the image detector is to be used for detecting diagnostic X-ray images of areas of a human or animal body. Typically, the array may be a 2000 x 2000 array of pixels. For convenience only a portion of the array is shown in full in Figure 2.

The thin-film transistor switching elements 30 are arranged in a matrix of 1-m rows and 1-n columns (only three rows and three columns are shown) with the gate of each transistor in a given row being connected to the same row conductor 41 of a row driver or decoder/addressing circuit 44 and the source of each transistor in a given column being connected to the same column conductor 42 of a column decoder/addressing circuit 45 including read out amplifiers as shown in Figure 1. The solid line 46 indicates the extent of the electromagnetic radiation detecting area of the photodetector array 2.

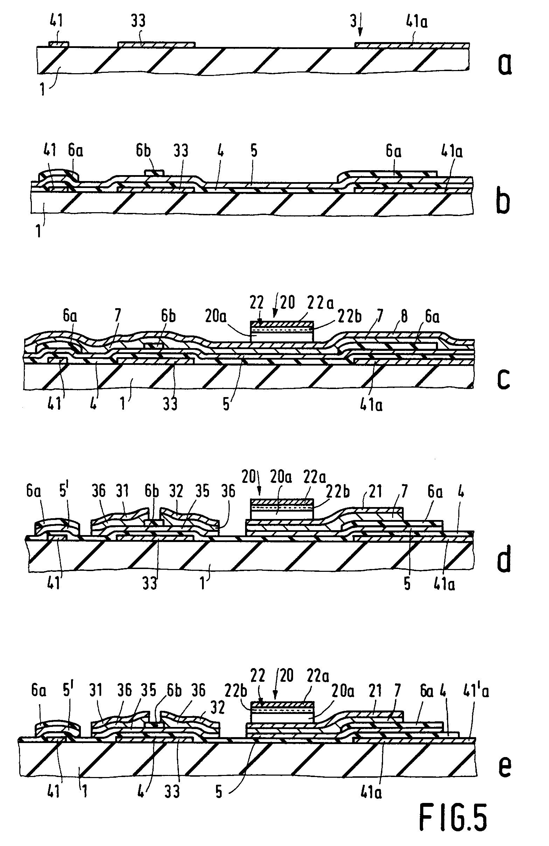

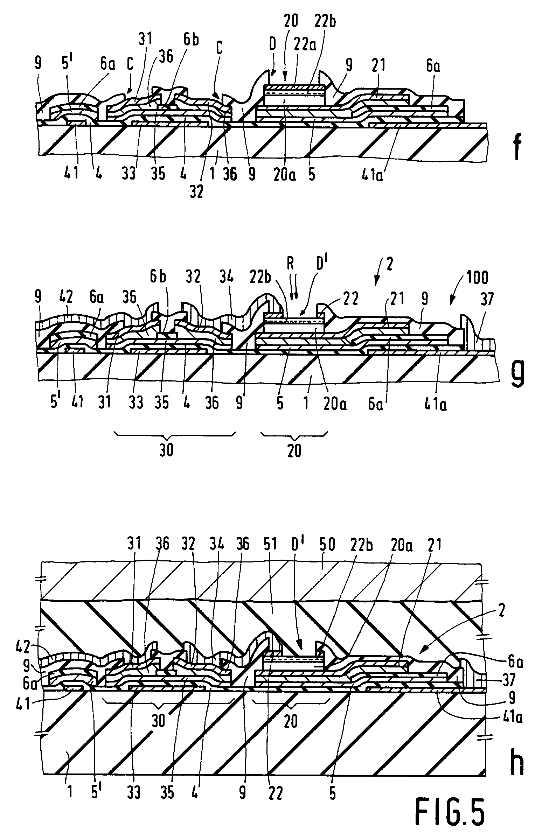

As will be described in greater detail below with reference to Figures 5a to 5g, the array 2 is manufactured by providing and patterning layers on an insulative substrate 1, generally a glass substrate.

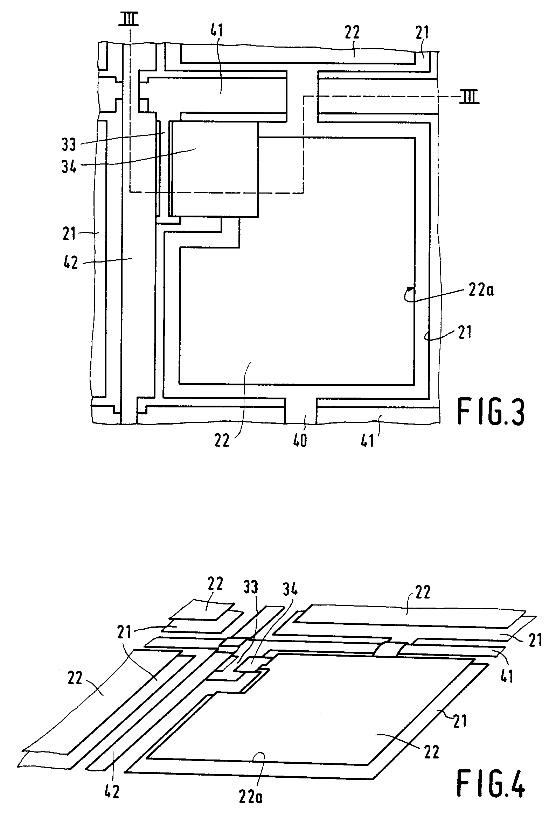

Figures 3 and 4 illustrate, by way of a plan view and a perspective view, respectively, the geometric layout and the relationship between the first and second electrodes 21 and 22 of a photosensitive element, in this case a photodiode 20 and the source, drain and gate electrodes 31,32 and 33 of the associated switching element 30 which together form one pixel of the array and the associated row and column conductors 41 and 42. In the interests of simplicity, all other structural features are omitted from Figures 3 and 4.

As can clearly be seen from Figures 3 and 4, the first electrode 21 of the photodiode 20 is larger in area than the second electrode 22 and extends laterally beyond the periphery 22a of the second electrode 22 in all directions. For convenience in forming a regular array 2, the electrodes 21 and 22 are formed so as to be rectangular, as shown square, in outline, however this need not necessarily be the case. Typically the first electrode 21 may extend laterally beyond the periphery 22a of the second electrode 22 for a distance of 5 to 10µm (micrometres).

As mentioned above, the first electrodes 21 of the photodiodes 20 are connected together to provide the common electrode 40 which in operation of the image detector, is connected to a fixed reference potential, which keeps the photodiodes 20 reverse biassed. In the case of an n-i-p diode (that is with the n layer adjacent the first electrode) the reference potential may be, for example, + 3 volts. The common electrode 40 extends over the row conductors 41 connecting the gate electrodes 33 in the row of transistors 30 but is at a level beneath the column conductors 42. The column conductors 42 connecting the source electrodes 31 of the transistors 30 in the columns of transistors 30 are provided at a metallisation level at which, as will be described below, an electrical connection 34 is provided between the drain electrode 32 of eachtransistor 30 and the second electrode 22 of the associated photodiode 20. The common electrode, where it is at an intermediate level between the row and column conductors, could be extended to act as a shield where the row and column conductors cross so as to reduce even further extraneous capacitance effects. As will be described below, the first electrode 21 of each photodiode 20 is formed from the same metallisation level as one of the electrodes of the associated transistor 30. Because the first electrodes 21 are connected to the common line 40, and are larger in area than the associated second electrodes 22, the first electrodes 21 act as a shield reducing unwanted parasitic capacitances especially that between the column conductors 42 and the second electrodes 22 so that this capacitance is effectively the source to drain capacitance of the switching element 30, that is no additional capacitance is measurable.

Where the array 2 has a pixel-to-pixel pitch of about 200µm (micrometres) with the first electrode 21 being about 165µm by 170µm and extending laterally beyond the second electrode 22 by about 10µm, then the parasitic capacitance between the read-out line or column conductor 42 and the picture element 20, will be about 4fF (Femtofarads, that is 4x10⁻¹⁵ Farads), which is in effect the source-drain capacitance of the transistor 30, while the capacitance between the column conductor 42 and the first electrode 21 (which as the common electrode 40 is connected to a fixed reference potential) will be typically 10 to 15fF. In addition, the larger area first electrodes serve to shield the photodiode array from back-illumination, that is from electromagnetic radiation incident via the substrate 1 which may be of particular advantae where the detector is to be used in a reflection-type document scanning or copying machine as the larger area first electrodes 21 will shield the photodiodes 20 from the direct incident electromagnetic radiation so that the photodiodes 20 detect only the electromagnetic radiation reflected from the document being scanned thereby improving sensitivity, espeically at low contrast levels.

Figures 5a to 5h are cross-sectional views taken along the dashed line III-III in Figure 3 of the substrate 1 and the layers carried thereby for illustrating one example of a method in accordance with the invention for manufacturing the image detector illustrated by Figures 3 and 4.

As indicated above, the substrate 1 is an insulative substrate, generally a glass substrate.

In this example, as shown in Figure 5a, a first metallisation level 3 is first provided on the substrate and patterned using a first mask (not shown) to define the control or gate electrodes 33 of the transistors 30, the gate lines or row conductors 41 and necessary connection areas 41a for enabling connections of the row conductors 41 to a higher metallisation level. The first metallisation level 3 may be provided by depositing a chrome layer.

An insulating layer 4, generally a silicon dioxide or silicon nitride layer, is then deposited followed by an intrinsic semiconductor layer 5, parts of which will later form the conduction channel regions of the transistors 30, and optionally a protective layer 6. The protective layer 6 is an insulating layer generally a silicon nitride layer. The protective layer 6 is patterned using a second mask (not shown) and conventional photolithographic and etching techniques to leave, as shown in Figure 5b, areas 6a over the row conductors 41 and the connection areas 41a so as to increase the thickness of overlying insulator, thereby reducing the parsitic capacitance, and the possibility of electrical shorts, between those regions of the first metallisation level 3 and subsequent overlying metallisation. A further area 6b of the protective layer is left over a central region of each transistor 30 so as to act as an etch stop. A doped, generally an n conductivity type, semiconductor layer 7 is then deposited followed by a second metallisation level or layer 8.

The doped semiconductor layer 7 may be formed of the same material as the intrinsic semiconductor layer 5, for example amorphous or polycrystalline silicon. The second metallisation layer 8 may be a chrome layer.

Further semiconductor layers are then deposited. Generally these will consist of an n conductivity type layer, an intrinsic type layer and a p conductivity type layer, followed by a transparent electrically conductive layer, for example an indium tin oxide (ITO) layer and a further chrome layer which acts to protect the ITO layer during subsequent processing. These layers are then sequentially patterned using a third single mask but different etching processes to define the photosensitive elements 20, such that each photosensitive element 20 consists (as shown in Figure 5c) of a n-i-p (that is with the n conductivity type layer adjacent the first electrode 21) active device region 20a diode structure (shown unhatched in the Figures) on top of the second metallisation layer 8 followed by a transparent ITO electrode portion 22b and a chrome electrode portion 22a with the transparent and chrome electrode portions 22b and 22c together forming the second electrode 22 of the photosensitive element 20.

A fourth mask is then provided and the second metallisation level 8, doped semiconductor layer 7 and intrinsic semiconductor layer 5 are then sequentially patterned using appropriate photolithographic and etching techniques to define, as illustrated in Figure 5d, the source and drain electrodes 31 and 32, source and drain n conductivity type contact regions 36 and an intrinsic conduction channel region 35 for each thin-film transistor 30 as well as the first electrode 21 of each photosensitive element 20. An area 5' of the layer 5 remains beneath the portion 6a of the protective layer. The source and drain contact regions 36 need not necessarily be provided in which case the layer 7 would be omitted. A fifth mask (not shown) is then used to enable the gate insulating layer 4 to be removed from part 41'a of the connection area 41a adjacent the periphery of the array to allow the final metallisation layer to contact the row conductors 41 as will be described below.

An insulating layer 9, formed of any suitable insulating material such as silicon nitride or polyimide, is then deposited and patterned using a sixth mask (not shown) and conventional techniques to define contact windows C (see Figure 5f) for enabling contact by subsequent metallisation and to define an opening D over the photosensitive element 20.

A final metallisation level 10, generally aluminium, is then deposited and patterned using a seventh mask (not shown) to define, as shown in Figure 5g, the column conductors 42 contacting the respective columns of source electrodes 31, the electrical interconnections 34 between respective drain electrodes 32 and second electrodes 22 and the metallisation 37 contacting the connection area 41a at the edge of the array. During the patterning of the final metallisation level 10, part of the chrome electrode portion 22a is removed to leave an opening D' over the second electrode 22 of the photosensitive element 20 to enable electromagnetic radiation R to be incident on the photosensitive element 20.

The electromagnetic radiation may be supplied directly to the photosensitive element 20 or may be converted electromagnetic radiation output from an energy conversion layer such as the layer 50 mentioned in connection with Figure 1. In the example illustrated in Figure 5h, the energy conversion layer may be provided directly onto the array 2. Where the energy conversion layer is electrically conductive or semiconductive, for example where a thallium-doped caesium iodide phosphor layer is used, a protective insulating layer 51 transparent to the converted electromagnetic radiation R is first provided over the array 2. The insulating layer 51 should be sufficiently thick, typically greater than 3µm (micrometres), to reduce capacitive coupling between the energy conversion layer 50 and the array. As an alternative, the energy conversion layer 50 may be provided on a separate substrate, for example an aluminium substrate, which is then mounted to the array in the manner described in our copending Application (our reference PHB33729).

The method described above with respect to Figures 5a to 5h enables an image detector in accordance with the invention to be manufactured using seven mask stages. Also, the common electrode 40 does not cross the readout electrode 42 which should reduce parasitic capacitance effects.

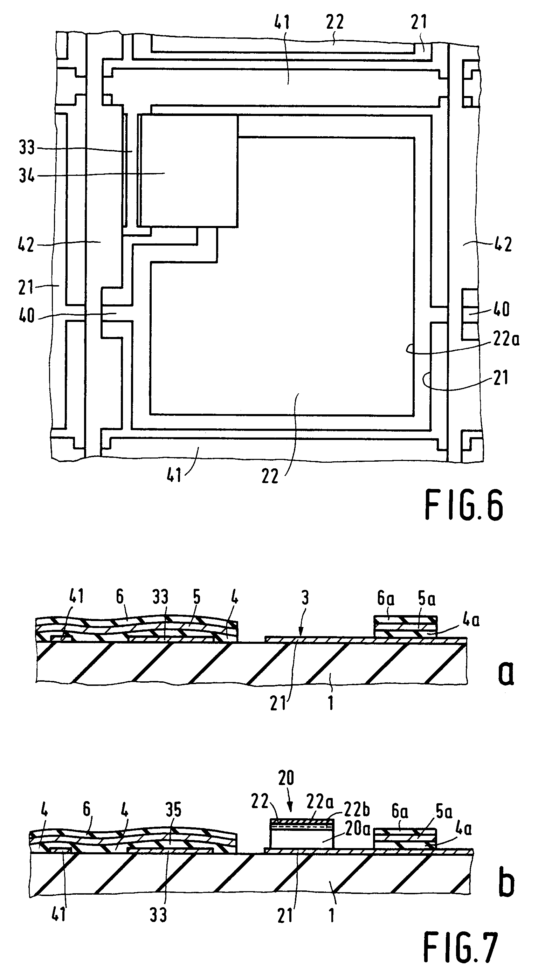

Figure 6 illustrates the layout of the electrodes for a modified image detector 100a in accordance with the invention. In this example, the first electrodes 21 of the photosensitive elements 20 are formed from the same metallisation level as the gate electrodes 33 and accordingly the common line or electrode 40 is provided at the same level as, and as shown in Figure 6 runs parallel to, the row conductors 41.

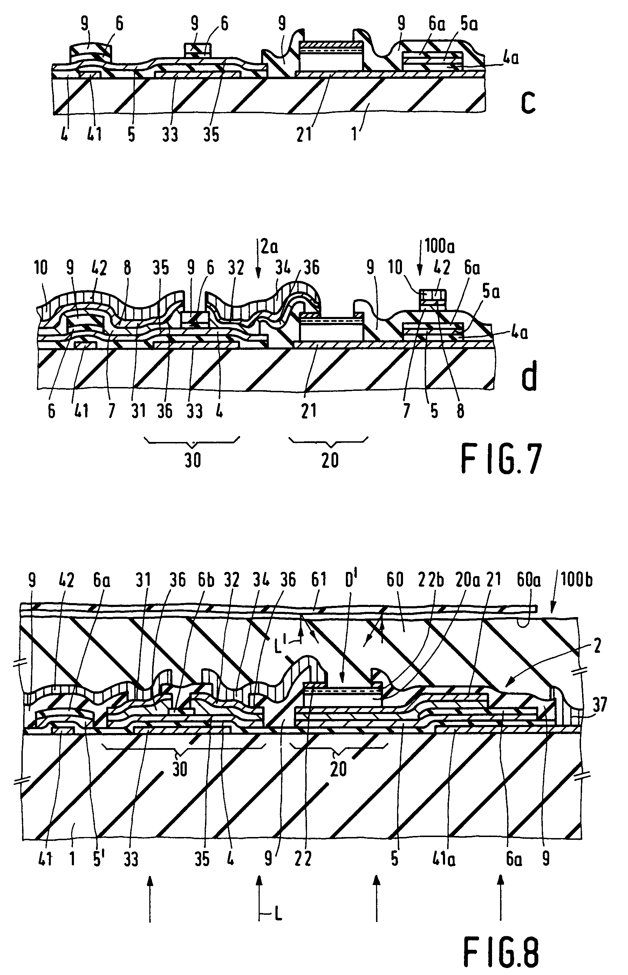

Figures 7a to 7d illustrate steps in a second example of a method for manufacturing the modified image detector 100a.

It should be noted that although Figures 7a to 7d show similar cross-sections to Figures 5a to 5d, the line of section in Figure 6 is along line VI-VI so that the final section along the row conductor 41 is not shown in Figures 7a to 7d. Also, as the method illustrated by Figures 7a to 7d is in some respects similar to that illustrated by Figures 5a to 5g, each mask stage is not shown separately.

In this example, as illustrated in Figure 7a, the first metallisation level 3 is again provided and patterned using a first mask (not shown). In this case, however, the first metallisation level 3 defines, in addition to the gate electrodes 33, the gate lines or row conductors 41 and necessary gate interconnections, and the first electrodes 21 of the photosensitive elements 20.

The insulating layer 4 and intrinsic semiconductor layer 5 are then deposited followed, where desired, by the protective layer 6 and patterned using a second mask (not shown) to define the conduction channel region 35 leaving a combination of the insulating layer 4 and intrinsic semiconductor layer 5 covering the gate lines or row conductors 41 to isolate the gate lines electrically from overlying layers and leaving portions 4a and 5a and 6a over an area of the common electrode 40 where a subsequent metallisation layer will cross.

The photosensitive element 20 is then defined in the same manner as that described above with reference to Figure 5c using a third mask to produce the structure shown in Figure 7b.

The insulating layer 9 is then deposited and patterned using a fourth mask (not shown) to produce the structure shown in Figure 7c. The doped semiconductor layer 7, where desired, is then deposited, followed by the second metallisation level 8 and the final metallisation level 10. All three layers 7,8 and 9 are then patterned sequentially using the same fifth mask (not shown) to define the source and drain contact regions 36 (if the doped semiconductor layer 7 is provided) and the source and drain electrodes 31 and 32, the interconnections 34 between respective drain electrodes 32 and second electrodes 22 and, although not shown, metallisation similar to metallisation 37 in Figures 5a to 5g contacting the gate lines 41 at the periphery of the array.

Using the method described with reference to Figures 7a to 7d requires, as described, the use of five masks which reduces the number of process steps and the process time and should reduce costs. A sixth mask may be required if layers 6 and 9 have different characteristics and cannot be deposited and/or etched together. In addition this method only requires the use of two levels of metallisation interconnects (the gate line layer 3 and the combined layers 8 and 10) because the final aluminium metallisation 10 is provided and patterned with the second chrome metallisation level 8. This should improve yield.

In the image detector manufactured using the method described with reference to Figures 7a to 7d, the common electrode 40 is formed from the same metallisation level as the gate electrode 33 and runs parallel to the gate electrode 33 (see Figure 6) so that the common electrode 40 has to cross the readout line 42. In an image detector manufactured using the method described with reference to Figures 5a to 5g the common electrode 40 crosses, rather than runs parallel to, the gate or row conductor 41 and is formed from the same metallisation level as the source and drain electrodes 31 and 32 so that the common electrode 40 does not cross the readout line 42 which should result in lower parasitic capacitances at the price of one or two additional masking steps.

In an image detector in accordance with the invention, the connection 34 between the drain electrode 32 of each transistor 30 and the second electrode 22 of the associated photosensitive diode 20 is accessible for testing by electrical probe enabling individual transistors 30 and diodes 20 within the array to be tested. Also, the first electrode 21 of each photodiode 20 is larger than the second electrode 22 and is connected to the common line 40 so that it acts as a screen to reduce the direct lateral capacitance between the pixel (photodiode 20) and the read-out line, that is the column conductor, 42. The larger area first electrodes 21 may also act as light shields against back-illumination which may be of particular advantage where the detector is to be used in a reflection-type document scanner. Using the present invention, the pixel to read-out line capacitance which can cause the changing signal (that is the electrical signal resulting from the electromagnetic radiation R incident on the photosensitive diode 20) on the pixel 20 to couple into the read-out line 42 is reduced so reducing any cross-talk which could otherwise cause image deterioration.

Although not shown in Figures 7a to 7d an energy conversion layer may be provided directly onto the array with, where appropriate, an intervening protective layer as in the example shown in Figure 5h or, for example, an energy conversion layer may be provided on a separate substrate mounted to the array.

The present invention may be applied to image detectors which do not require the use of energy conversion layers, that is to detectors for detecting visible light and may be used for many different applications, for example position sensitive detectors, contact non-scanning facsimile sensors, interactive displays and other similar devices.

Figure 8 illustrates a further example of an image detector 100b in accordance with the invention.

The image detector 100b shown in Figure 8 is similar to that shown in Figure 5g. The image detector 100b has, however, a special protective layer 60 covering the array of photosensitive elements 20 and associated switching elements 30. The protective layer 60 is arranged to be transparent to electromagnetic radiation detectable by the photosensitive elements 20. The substrate 1 is as in the previous example a glass substrate, typically 1 to 2mm thick, but could be made of any suitable material which is transprent to the electromagnetic radiation detectable by the photosensitive elements 20.

The protective layer 60 provides a surface 60a onto which an object, such as a document, 61 may be placed so that the document is in intimate contact with the image detector.

The protective layer 61 may be formed of any suitable electrically insulating material, for example a polyimide, silicon dioxide or silicon nitride. Where a polyimide or similar flowable then settable layer is used to form the protective layer then it may provide additional advantages in planarising the surface 60a to provide a flat surface onto which the document 61 to be imaged can be placed. This may assist in reducing possible distortions in the image.

In the example illustrated in Figure 8, a certain percentage of the total area of each pixel is transparent to electromagnetic radiation detectable by the photosensitive elements 20. Where the pixels have a geometric layout similar to that shown in Figure 3, then the areas between the various metallisation areas will be transparent to the electromagnetic radiation, that is the areas not covered by any of the first electrodes 21 and the interconnections to form the common line 40, the row conductors 41 and associated gate electrodes, the readout lines 42 and the source and drain electrodes 31 and 34. The actual percentage of the total area of each pixel which is transparent to electromagnetic radiation detectable by the photosensitive elements 20 will depend upon the precise dimensions of the various elements within each pixel and upon the particular chosen gemoetry but as an example, with the geometrical layout of Figure 3, approximately 40% of the total area of each pixel may be capable of transmitting or passing electromagnetic radiation detectable by the photosensitive elements 20.

The actual size (number of pixels) of the array and the pixel-to-pixel pitch will depend upon the precise application and the resolution required. For example, for a detector 100b to be used as a document reader operating at A4 size (approximately 30cm by 21cm (centimetres)) and for a resolution of about 10 to 12 lines per mm (millimetre), a pixel-to-pixel pitch of about 80 to 100µm is required. Thus, the array would have up to 4000 x 4000 elements or pixels. The thickness of the protective layer 60 should be small in relation to the pixel-to-pixel pitch and may be, typically, between 1 and 5µm (micrometres).

In operation of the image detector 100b shown in Figure 8, electromagnetic radiation L detectable by the photosensitive elements 20 is provided by a conventional source so as to be incident on the substrate 1. The electromagnetic radiation L' passing through the substrate 1 and the protective layer 60 is incident on the document 61 and is scattered or reflected back onto the photosensitive elements 20 which, under the control of the switching elements 30, store charge representing an image of the document 61. The stored image can then be read out via the readout lines 42 and, for example, further processed to provide video signals for a cathode ray tube or to provide electronic signals for transmission over telephone lines between facsimile machines.

Good quality images have been obtained from a variety of different document materials, including transparencies, although for the best results the document surface should be a good scatterer for the electromagnetic radiation L'.

As indicated above, the first electrodes 21 are larger than the second electrodes 22 and also are larger than the active area 20a of the photosensitive elements 20 and so act to shield the photosensitive elements from the electromagnetic radiation L indicent on the substrate 1 so that only the electromagnetic radiation reflected or scattered by the object being imaged is detected by the photosensitive elements.

The protective layer 60 inhibits mechanical damage of the image detector and also provides a barrier to moisture in the document 61 which might otherwise cause parasitic leakage currents.

The image detector 100b shown in Figure 8 enables true contact images to be formed and stored without the need for the use of lenses or light guiding arrangements while the use of a two dimensional array sensor has the advantage of enabling a two dimensional image to be produced at high operating speeds without the need for any mechanical components. The image detector 100b produces an image with a resolution comparable, generally identical, to that of the pixel array and accordingly the desired resolution can be achieved by appropriate selection of the pixel-to-pixel array pitch.

Although the photosensitivity of the switching elements 30 is not, especially where the switching elements are thin-film transistors with an inverted staggered structure, considered to be sufficiently large to constitute a problem, if necessary a mask layer, similar to those already used in liquid crystal displays, may be provided to shield the switching elements 30 from the incident radiation R.

Other types of switching elements may be used, for example although the embodiments described above show inverted staggered thin-film transistors, non-staggered thin-film transistors may be used. Also photosensitive elements other than n-i-p diodes can be used. Thus, for example p-i-n diodes (that is where the p conductivity layer is adjacent the first electrode 21) may be used. The use of n-i-p diodes is, however, preferred as they have a greater quantum efficiency that p-i-n diodes. As other alternatives, photosensitive Schottky diodes or photosensitive resistors could be used.

From reading the present disclosure, other modifications and variations will be apparent to persons skilled in the art. Such modifications and variations may involve other features which are already known in the art and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

## Claims

1. An image detector comprising a substrate carrying a series of layers of different materials patterned to define an array of photosensitive elements each having first and second opposed electrodes with the first electrode being closer to the substrate than the second electrode and a plurality of switching elements, each switching element having first and second main electrodes and a control electrode with the second main electrode of each switching element being connected to the second electrode of an associated one of the photosensitive elements and the first electrodes of the photosensitive elements being connected to a common line, characterised in that each photosensitive element has a first electrode which is larger in area than its second electrode so that the first electrode extends laterally beyond the periphery of the second electrode and in that the first electrode of each photosensitive element is formed from the same layer as one of the electrodes of the associated switching element.

2. An image detector according to Claim 1, further characterised in that the photosensitive elements are arranged in a regular matrix of rows and columns of photosensitive elements, in that the control electrodes of the switching elements associated with a row of photosensitive elements are connected together to a respective row electrode and in that the first main electrodes of the switching elements associated with a column of photosensitive elements are connected together to a respective column electrode.

3. An image detector according to Claim 1 or 2, further characterised in that the first electrodes of the photosensitive elements are formed from the same layer as the first main electrodes of the switching elements.

4. An image detector according to Claim 1 or 2, further characterised in that the first electrodes of the photosensitive elements are formed from the same layer as the control electrodes of the switching elements.

5. An image detector according to Claim 1,2,3 or 4, further characterised in that the control electrodes are formed by a layer adjacent the substrate.

6. An image detector according to any one of the preceding claims, further characterised in that the switching elements comprise thin-film transistors and the photosensitive elements comprise photosensitive diodes.

7. An image detector according to any one of the preceding claims, further characterised in that an energy conversion layer is provided for converting electromagnetic radiation with a first range of wavelengths into electromagnetic radiation with a second range of wavelengths detectable by the photosensitive elements.

8. An image detector according to Claim 7, further characterised in that the energy conversion layer comprises a phosphor layer.

9. An image detector according to Claim 7 or 8, further characterised in that the energy conversion layer is provided on a protective insulating layer provided over the photosensitive and switching elements, the protective insulating layer being at least partially transparent to electromagnetic radiation detectable by the photosensitive elements.

10. An image detector according to any one of Claims 1 to 6, further characterised in that a protective layer is provided on the substrate to cover the array of photosensitive elements and associated switching elements, the substrate and the protective layer being at least partially transparent to electromagnetic radiation detectable by the photosensitive elements for enabling the photosensitive elements to detect electromagnetic radiation which has passed through the substrate and been reflected onto the photosensitive elements by an object placed on the protective layer.

11. An image detector according to Claim 10, further characterised in that the protective layer comprises a material selected from the group consisting of polyimide, silicon dioxide and silicon nitride.

12. A method of manufacturing an image detector, which method comprises providing a series of layers of different materials on a substrate and patterning the layers to define an array of photosensitive elements each having first and second opposed electrodes with the first electrode being closer to the substrate and a plurality of switching elements, each switching element having first and second main electrodes and a control electrode with the second main electrode of each switching element being connected to the second electrode of an associated one of the photosensitive elements and the first electrodes of the photosensitive elements being connected to a common line, characterised by forming the first electrode of each photosensitive element to be larger in area than its second electrode so that the first electrode extends laterally beyond the periphery of the second electrode and forming the first electrode of each photosensitive from the same layer as one of the electrodes of the associated switching element.

13. A method according to Claim 12, further characterised by forming the first electrodes of the photosensitive elements from the same layer as the first electrodes of the switching elements.

14. A method according to Claim 13, further characterised by providing a first conductive layer on the substrate and patterning the first conductive layer to define the control electrodes, providing at least one semiconductor layer on the first conductive layer, providing a second conductive layer over the semiconductor layer and patterning the semiconductor layer and the second conductive layer to define active device regions of the switching elements and the first and second electrodes of the switching elements and the first electrodes of the photosensitive elements, providing at least one further semiconductor layer over the second conductive layer and patterning the further semiconductor layer to define active regions of the photosensitive elements, providing an isolating insulative layer over the further semiconductor layer, patterning the insulating layer to define contact windows and providing a third conductive layer connect the second electrode of each photosensitive element to the second main electrode of the associated switching element.

15. A method according to Claim 12, further characterisedby forming the first electrodes of the photosensitive elements from the same layer as the control electrodes of the switching elements.

16. A method according to Claim 15, further characterised by providing a first conductive layer on the substrate and patterning the first conductive layer to define the control electrodes of the transistors and the first electrodes of the photosensitive elements, providing at least one semiconductor layer on the first conductive layer and patterning the semiconductor layer to define active device regions of the switching elements and of the photosensitive elements, providing at least one further conductive layer over the semiconductor layer and patterning the at least one further conductive layer to define the first and second electrodes of the switching elements and to connect the second electrode of each photosensitive element to the second main electrode of the associated switching element.

17. A method according to any one of Claims 12 to 16, further characterised by providing an energy conversion layer over the structure on the substrate for converting electromagnetic radiation with a first range of wavelengths into electromagnetic radiation with a second range of wavelengths detectable by the photosensitive element.

18. A method according to any one of Claims 12 to 17, further characterised by providing a protective layer on the substrate to cover the array of photosensitive elements and associated switching elements, the substrate and the protective layer being at least partially transparent to electromagnetic radiation detectable by the photosensitive elements for enabling the photosensitive elements to detect electromagnetic radiation which has passed through the substrate and been reflected onto the photosensitive elements by an object placed on the protective layer.

19. A method according to Claim 18, further characterised by providing the protective layer as a layer of a material selected from the group consisting of polyimide, silicon dioxide and silicon nitride.

20. An image detector comprising a substrate carrying a series of layers of different materials patterned to define an array of photosensitive elements each having an active device area bounded by first and second opposed electrodes with the first electrode being closer to the substrate than the second electrode and being larger in area than the second electrode so that the first electrode extends laterally beyond the periphery of the active device area and the second electrode, and a plurality of switching elements associated with the photosensitive elements for controlling the storage by and readout of information from the photosensitive elements, a protective layer being provided on the substrate to cover the array of photosensitive elements and associated switching elements, the substrate and the protective layer being at least partially transparent to electromagnetic radiation detectable by the photosensitive elements for enabling the photosensitive elements to detect electromagnetic radiation which has passed through the substrate and been reflected from an object placed on the protective layer.

21. A method of obtaining an image of an object, which method comprises placing the object on the protective layer of an image detector in accordance with Claim 10, 11 or 20, and directing electromagnetic radiation detectable by the photosensitive elements through the substrate onto the object so that electromagnetic radiation reflected by the object is detected by the photosensitive elements.
